# EUROPEAN PATENT APPLICATION

(11) **EP 3 734 304 A1**
(43) Date of publication of application: **04.11.2020**
(21) Application number: 19172493.9
(22) Date of filing: 03.05.2019
(51) Int. Cl.: G01R 31/28

(54) **CRYOGENIC PROBE STATION**

(71) Applicant: Afore Oy, 21420 Lieto (FI); BlueFors Cryogenics Oy, 00370 Helsinki (FI)
(72) Inventor: JUNES, Aki, 20100 Turku (FI); KUUKKALA, Ari, 20540 Turku (FI); SALMINEN, Timo, 20750 Turku (FI); HENTTONEN, Vesa, 20380 Turku (FI); MANNINEN, Matti, 02340 Espoo (FI); GUNNARSSON, David, 00370 Helsinki (FI); ROSCHIER, Leif, 01600 Vantaa (FI)
(74) Representative: Berggren Oy, Turku

(57) **Abstract**

The present invention provides a testing device (100) for electrically testing integrated circuits on a wafer (102). The testing device (100) comprises a vacuum chamber (109), a chuck (101) inside the vacuum chamber (109) for holding the wafer (102), a probe card (103) inside the vacuum chamber (109) for electrically contacting the integrated circuits on the wafer (102), and a cooling unit (114) that is thermally connected to the chuck (101) and/or the probe card (103).

## Description

### TECHNICAL FIELD OF THE INVENTION

The present invention relates to a testing device according to the preamble of the appended independent claim.

### BACKGROUND OF THE INVENTION

Semiconductor device fabrication is a commonly used process for creating integrated circuits on a wafer made of a semiconductor material using multiple-step sequence of photolithographic and chemical processing steps. As a part of the process, the integrated circuits created on the wafer are typically tested for functional defects by applying special test patterns to them. This testing is performed by using a testing device called a wafer prober.

An example of a known wafer prober comprises a chuck for holding a wafer to be tested and a probe card for electrically contacting integrated circuits on the wafer. The probe card is electrically connected to an electronic testing unit that electrically tests the integrated circuits according to a test program. The test program defines the contents of test patterns and the sequence by which they are applied to the integrated circuits. The chuck and the probe card are arranged inside a chamber, which allows the integrated circuits to be tested in a controlled environment. For electrical testing, the probe card is held in place while the wafer mounted on the chuck is moved between testing positions. In each testing position, contact elements of the probe card are arranged in electrical contact with contact pads of a set of integrated circuits, which are then electrically tested with the electronic testing unit.

A problem associated with known wafer probers is that testing of integrated circuits is difficult or even impossible at very low temperatures, especially below 4 K.

### OBJECTIVES OF THE INVENTION

It is the main objective of the present invention to reduce or even eliminate the prior art problems presented above.

It is an objective of the present invention to provide a testing device for electrically testing integrated circuits on a wafer. In more detail, it is an objective of the invention to provide a testing device enabling to electrically test integrated circuits on a wafer at very low temperatures, and even below 4 K. It is a further objective of the present invention to provide a testing device enabling to quickly and energy efficiently cool a wafer to a desired testing temperature and to maintain the temperature using a minimum amount of energy. It is yet a further objective of the present invention to provide a testing device where the space in which integrated circuits are tested is well thermally shielded from its surrounding.

In order to realise the above-mentioned objectives, the testing device according to the invention is characterised by what is presented in the characterising portion of the appended independent claim. Advantageous embodiments of the invention are described in the dependent claims.

### DESCRIPTION OF THE INVENTION

A testing device according to the invention comprises a vacuum chamber, a chuck inside the vacuum chamber for holding a wafer that comprises integrated circuits, and a probe card inside the vacuum chamber for electrically contacting the integrated circuits on the wafer. The testing device according to the invention further comprises a cooling unit that is thermally connected to the chuck and/or the probe card.

The testing device according to the invention can be used for electrically testing integrated circuits on a wafer. This testing device can be called as a wafer prober. The wafer to be tested is mounted on the chuck, which is moved between testing positions. In each testing position, the probe card is in electrical contact with one or more integrated circuits, which can then be electrically tested.

The chuck is used to hold the wafer during testing of the integrated circuits. The chuck can be, for example, a mechanical chuck that comprises a plurality of heat conducting pins for holding the wafer on a base plate of the chuck. Alternatively, the chuck can be, for example, an electrostatic chuck that comprises a metal base plate coated with a layer of dielectric material. By providing a voltage difference between the metal base plate and the wafer, an electrostatic force holds the wafer on the chuck. To maintain the flatness of the wafer and facilitate the rapid transfer of heat from the wafer, the chuck is preferably made of a heat conducting material, such as copper or gold. The chuck can be made of gold-plated copper. These materials provide good thermal properties and performance.

The probe card is used to electrically contact the integrated circuits on the wafer. The probe card may comprise a printed circuit board (PCB) and one or more contact elements, which can be arranged in electrical contact with contact pads of the integrated circuits. The testing device may comprise a camera for optically locating the contact elements on the probe card and the contact pads on the wafer. By using this information, the contact pads of the integrated circuits to be tested can be aligned to the contact elements of the probe card.

The probe card can be thermally and mechanically attached to a probe card holder that is mechanically attached to but thermally isolated from the vacuum chamber or a radiation shield arranged inside the vacuum chamber. The probe card can be, for example, a needle, vertical pin, or MEMS (Micro Electro-Mechanical System) type probe card depending on the shape and form of the contact elements. The contact elements of the probe card can, for example, be made of tungsten or a tungsten/rhenium alloy. The contact pads of the integrated circuits can, for example, be made of aluminium, copper, copper alloys or many types of solders such as lead-tin and tin-silver. Typically, the probe card is custom-built for each type of wafer so that every integrated circuit on the wafer can be electrically tested.

The chuck and the probe card are arranged inside the vacuum chamber, which allows the integrated circuits to be tested in a controlled environment. The conditions such as the pressure and temperature inside the vacuum chamber can be controlled using various devices. The testing device may comprise, for example, a vacuum pump connected to the vacuum chamber for controlling the pressure and a cooling unit connected to the vacuum chamber for controlling the temperature inside the vacuum chamber. The vacuum chamber can, for example, be made of stainless steel or aluminium. When testing the integrated circuits, the pressure inside the vacuum chamber is typically less than 10E-4 mbar.

The cooling unit is thermally connected to the chuck and/or the probe card, preferably to both the chuck and the probe card. In this text, the expression "thermally connected" means that two members are connected such that heat can be conducted therebetween. The cooling unit is used for cooling the chuck and/or the probe card. As the chuck is cooled by the cooling unit, heat from the wafer that is mounted on the chuck may transfer to the chuck by conduction. Correspondingly, as the probe card is cooled by the cooling unit, heat from the wafer may transfer to the probe card when the probe card is in electrical contact with the integrated circuits. Heat is transferred by conduction through the contact pads of the integrated circuits and the contact elements of the probe card. The cooling unit thus enables to efficiently cool the wafer through the chuck and/or the probe card. With this arrangement, the wafer can be cooled to a very low temperature, such as below 4 K.

Heat is transferred away from the chuck through one or more thermal links connected between the chuck and the cooling unit. Heat is transferred away from the probe card through one or more thermal links connected between the probe card and the cooling unit. Preferably, the cooling unit is thermally connected to the probe card through the probe card holder. The thermal link can be, for example, a cable or bar made of copper or aluminium.

The testing device may comprise means for moving the chuck relative to the probe card. The moving means may comprise an actuator for moving the chuck in three perpendicular directions and another actuator for rotating the chuck around an axis. The actuators are preferably arranged outside the vacuum chamber so that the heat generated by the actuators does not heat the space in which integrated circuits are tested. The moving means may comprise a supporting column having a first end and a second end. The first end of the supporting column can be attached to the chuck and the second end of the supporting column to the actuators. The movement produced by the actuators is thus transferred through the supporting column to the chuck. The supporting column can be made of a metal, such as stainless steel, or other material having good mechanical properties and a low thermal conductivity. The supporting column can be a one-piece or multi-piece tube that can be made of a sheet metal. The wall thickness of the tube can be in the range of 0.05 mm to 0.3 mm, which ensures that the heat transfer through the supporting column is minimal, while at the same time the supporting column is rigid enough to retain its shape.

The testing device may comprise an electronic testing unit for electrically testing the integrated circuits on the wafer. The electronic testing unit is electrically connected to the probe card. Preferably, the electronic testing unit is arranged outside the vacuum chamber. The probe card provides an electrical path between the electronic testing unit and the integrated circuits on the wafer, thereby permitting the testing and validation of the integrated circuits. The electronic testing unit tests the integrated circuits according to a test program, which defines the contents of test patterns and the sequence by which they are applied to the integrated circuits. The electronic testing unit may comprise a processor and a memory including computer program code, the memory and the computer program code being configured to, with the processor, cause the electronic testing unit to electrically test the integrated circuits.

An advantage of the testing device according to the invention is that it enables to electrically test integrated circuits on a wafer at very low temperatures, and even below 4 K. Another advantage of the testing device according to the invention is that the wafer can be quickly and energy efficiently cooled to a desired testing temperature and the temperature can be maintained using a minimum amount of energy.

According to an embodiment of the invention the testing device comprises one or more nested radiation shields inside the vacuum chamber, the chuck and the probe card being arranged inside the innermost radiation shield. In other words, the testing device may comprise one radiation shield inside which the chuck and the probe card are arranged, or a plurality of nested radiation shields wherein the chuck and the probe card are arranged inside the innermost radiation shield. The number of the radiation shields can be, for example, 1, 2, 3, 4 or more than 4.

The radiation shield acts as a thermal shield, reducing the heat transfer. In other words, the radiation shield is a thermal radiation shield. The radiation shield defines an essentially enclosed space into which the chuck and the probe card and possibly one or more other nested radiation shields are placed. The radiation shield may consist of one or more shield parts. The radiation shield can be attached to the vacuum chamber or to another radiation shield that encloses it. The radiation shield can comprise a cylindrical side wall, an upper end wall attached about its perimeter to the upper edge of the side wall, and a lower end wall attached about its perimeter to the lower edge of the side wall. The radiation shield can, for example, be made of aluminium.

An advantage of the one or more nested radiation shields is that the space in which integrated circuits are tested is well thermally shielded from its surrounding. The radiation shields improve the heat shielding of the testing device, whereby the desired testing temperature of the wafer can be achieved and maintained using less energy than in a testing device without radiation shields.

Radiative heat transfer (emission/absorption) can be reduced by making surfaces of the radiation shield(s) and the inner surface of the vacuum chamber reflecting. The heat reflecting surface can be, for example, polished metal. The fraction of the heat reflecting surfaces can be maximized and only the non-idealities, such as gaps in the geometry are compensated by making the surfaces locally heat absorbing. The heat absorbing surface can be, for example, black anodized or painted in black.

According to an embodiment of the invention the cooling unit is thermally connected to the one or more nested radiation shields. The heat is transferred out of the radiation shield through one or more thermal links connected between the radiation shield and the cooling unit. The thermal link can be, for example, a cable or bar made of copper or aluminium.

The cooling unit may have a plurality of temperature stages, which are thermally connected to the chuck and the probe card and to different radiation shields. The temperature stages of the cooling unit are configured to provide different temperatures. The temperature stage that provides the lowest temperature can be thermally connected to the chuck and the probe card. The temperature stage that provides the second lowest temperature can be thermally connected to the innermost radiation shield, the temperature stage that provides the third lowest temperature can be thermally connected to the second innermost radiation shield, and so on. By using the temperature stages, the chuck and the probe card can be cooled to a temperature in the range of 0.8-1.2 K, or about 1 K, the innermost radiation shield can be cooled to a temperature in the range of 3-5 K, or about 4 K, and the second innermost radiation shield can be cooled to a temperature in the range of 45-55 K, or about 50 K.

An advantage of the cooling unit having a plurality of temperature stages is that the space in which integrated circuits are tested, i.e. the interior of the innermost radiation shield, can be more quickly and energy efficiently cooled to a desired temperatu re.

According to an embodiment of the invention the cooling unit is a dry cryostat using a closed loop helium circulation. When the dry cryostat is used, the vacuum chamber is kept at room temperature (not in a liquid nitrogen or liquid helium bath) and all the low temperature components are located inside the vacuum chamber. The dry cryostat may comprise a plurality of temperature stages, for example, 50 K, 4 K and 1 K stages. An advantage of the dry cryostat is that the wafer can be cooled to a temperature below 4 K without immersing the whole system into a liquid helium bath.

According to an embodiment of the invention the probe card comprises a plurality of heat conducting layers which are thermally connected to each other. The heat conducting layers are thermally connected to each other with heat conducting elements, such as copper vias. The heat conducting layers and elements can, for example, be made of copper. The number of the heat conducting layers can be, for example, 2-10 or 3-5. An advantage of the heat conducting layers is that they improve the heat conduction and thus accelerate the cooling of the probe card. Another advantage of the heat conducting layers is that they locally reduce the temperature of the wafer near the measured integrated circuit.

According to an embodiment of the invention the thickness of the heat conducting layers is less than 1 mm. Preferably, the thickness of the heat conducting layers is in the range of 0.2 mm to 0.5 mm.

According to an embodiment of the invention the heat conducting layers are made of copper, copper alloy, gold, gold alloy, silver or silver alloy. These materials have a good thermal conductivity.

According to an embodiment of the invention the chuck comprises a plurality of heat conducting pins for holding the wafer on a base plate of the chuck. The heat conducting pins conduct heat from the wafer to the chuck that is thermally connected to the cooling unit for transferring heat away from the chuck. The number of the heat conducting pins can be, for example, 3, 4, 5 or more than 5. The heat conducting pins can, for example, be made of copper. The base plate is made of a heat conducting material, such as copper or gold, or gold-plated copper, which enables heat to be efficiently conducted from the wafer to the base plate.

According to an embodiment of the invention the heat conducting pins are attached to the periphery of the base plate. The heat conducting pins are thus arranged to contact the outer edge of the wafer in order to hold the wafer on the base plate.

According to an embodiment of the invention at least one of the heat conducting pins is attached with a spring to the periphery of the base plate, the spring being movable in the plane of the base plate. The spring-operated pin can be moved with an end defector of a wafer loading arm that loads the wafer onto the chuck. The spring ensures a good contact between the wafer and the heat conducting pins, and thus improves heat conduction from the wafer to the chuck.

According to an embodiment of the invention an outer end of the heat conducting pins has a shape of a truncated cone enabling to press the wafer against the base plate. The shape of the truncated cone ensures a good contact between the wafer and the heat conducting pins and the base plate, and thus improves heat conduction from the wafer to the chuck.

The exemplary embodiments of the invention presented in this text are not interpreted to pose limitations to the applicability of the appended claims. The verb "to comprise" is used in this text as an open limitation that does not exclude the existence of also unrecited features. The features recited in the dependent claims are mutually freely combinable unless otherwise explicitly stated.

### BRIEF DESCRIPTION OF THE DRAWINGS

- Fig. 1: illustrates a sectional view of a testing device according to an embodiment of the invention,
- figs. 2A-2B: illustrate an exemplary chuck, and
- fig. 3: illustrates an exemplary probe card.

### DETAILED DESCRIPTION OF THE DRAWINGS

The same reference signs are used of the same or like components in different embodiments.

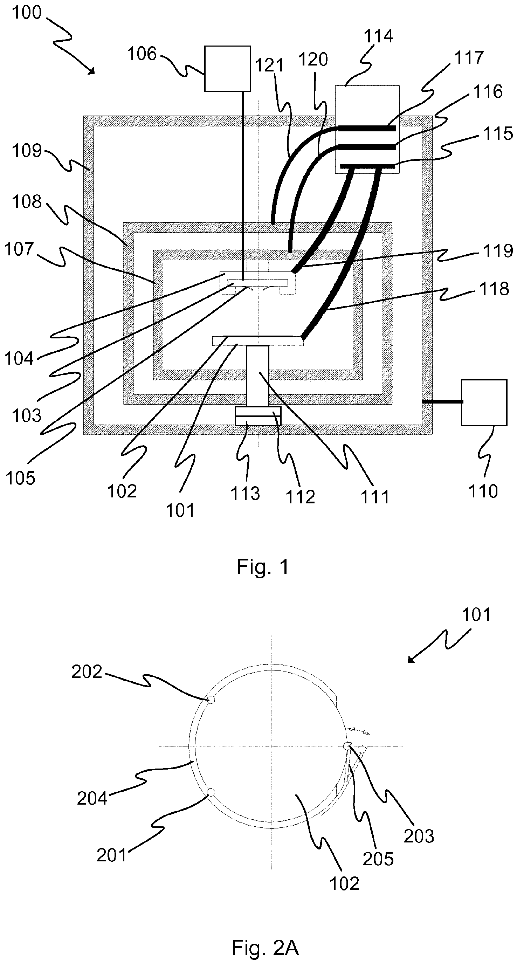

Fig. 1 illustrates a sectional view of a testing device according to an embodiment of the invention. The testing device 100 comprises a chuck 101 for holding a wafer 102 that comprises integrated circuits, and a probe card 103 attached to a probe card holder 104 for electrically contacting the integrated circuits on the wafer 102. The probe card 103 comprises contact elements 105, which can be arranged in electrical contact with contact pads of the integrated circuits. The electrical testing of the integrated circuits is done with an electronic testing unit 106 that is electrically connected to the probe card 103. The probe card 103 provides an electrical path between the electronic testing unit 106 and the integrated circuits on the wafer 102.

The testing device 100 comprises two nested radiation shields 107 and 108, which are arranged inside a vacuum chamber 109. The chuck 101 and the probe card 103 are arranged inside the innermost radiation shield 107. The vacuum chamber 109 allows the integrated circuits to be tested in a controlled environment. The pressure inside the vacuum chamber 109 is controlled with a vacuum pump 110.

The chuck 101 can be moved relative to the probe card 103 with moving means that comprise a supporting column 111 having a first end and a second end. The first end of the supporting column 111 is attached to the chuck 101 so that the chuck 101 is perpendicular with respect to the longitudinal axis of the supporting column 111. The moving means also comprise an actuator 112 for moving the supporting column 111 in three perpendicular directions, and an actuator 113 for rotating the supporting column 111 around its longitudinal axis. The actuators 112 and 113 are attached to the second end of the supporting column 111 so that the movement is transferred through the supporting column 111 to the chuck 101. The supporting column 111 is arranged to pass through the walls of the radiation shields 107 and 108 so that the first end of the supporting column 111 extends into the interior of the radiation shield 107, and the second end of the supporting column 111 extends out of the radiation shield 108.

The testing device 100 comprises a cooling unit 114 for cooling the wafer 102 to a desired testing temperature and for maintaining the testing temperature during testing of the integrated circuits. The cooling unit 114 comprises three temperature stages 115, 116 and 117, each of which is configured to provide a specific temperature to a part to which it is thermally connected. The first temperature stage 115 is thermally connected to the chuck 101 and the probe card 103. The temperature that can be achieved with the first temperature stage 115 is lower than the temperature that can be achieved with the second and third temperature stages 116 and 117. The heat is transferred away from the chuck 101 through a thermal link 118 connected between the first temperature stage 115 and the chuck 101. The heat is transferred away from the probe card 103 through a thermal link 119 connected between the first temperature stage 115 and the probe card holder 104. The second temperature stage 116 is thermally connected to the radiation shield 107 and the third temperature stage 117 is thermally connected to the radiation shield 108. The temperature that can be achieved with the second temperature stage 116 is lower than the temperature that can be achieved with the third temperature stage 117. The heat is transferred out of the radiation shield 107 through a thermal link 120 connected between the second temperature stage 116 and the radiation shield 107. The heat is transferred out of the radiation shield 108 through a thermal link 121 connected between the third temperature stage 117 and the radiation shield 108.

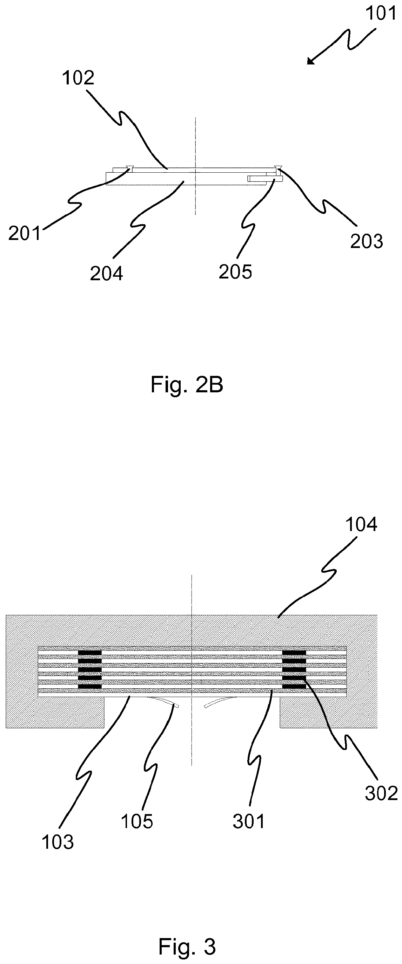

Figs. 2A-2B illustrate an exemplary chuck for holding a wafer. Fig. 2A illustrates a top view and fig. 2B a side view of the chuck. The chuck 101 comprises three heat conducting pins 201, 202 and 203 for holding the wafer 102 on a base plate 204 and for conducting heat from the wafer 102 to the base plate 204. The heat conducting pins 201, 202 and 203 are attached to the periphery of the base plate 204 enabling the heat conducting pins 201, 202 and 203 to contact the outer edge of the wafer 102 in order to hold the wafer 102 on the base plate 204. An outer end of the heat conducting pins 201, 202 and 203 has a shape of a truncated cone enabling to press the wafer 102 against the base plate 204. The heat conducting pin 203 is attached with a spring 205 to the periphery of the base plate 204. The spring 205 is movable in the plane of the base plate 204. The spring-operated pin 203 can be moved with an end defector (not shown in figs. 2A-2B) that loads the wafer 102 onto the chuck 101.

Fig. 3 illustrates an exemplary probe card for electrically contacting integrated circuits on a wafer. The probe card 103 that is attached to a probe card holder 104 comprises heat conducting layers 301, which are thermally connected to each other with heat conducting elements 302. Heat can transfer from the wafer to the probe card 103 when the probe card 103 is in electrical contact with the integrated circuits. Heat is transferred by conduction through contact pads of the integrated circuits and contact elements 105 of the probe card 103.

Only advantageous exemplary embodiments of the invention are described in the figures. It is clear to a person skilled in the art that the invention is not restricted only to the examples presented above, but the invention may vary within the limits of the claims presented hereafter. Some possible embodiments of the invention are described in the dependent claims, and they are not to be considered to restrict the scope of protection of the invention as such.

## Claims

1. A testing device, comprising:
- a vacuum chamber,
- a chuck inside the vacuum chamber for holding a wafer that comprises integrated circuits, and
- a probe card inside the vacuum chamber for electrically contacting the integrated circuits on the wafer,
**characterised in that** the testing device comprises a cooling unit that is thermally connected to the chuck and/or the probe card.

2. The testing device according to claim 1, **characterised in that** the testing device comprises one or more nested radiation shields inside the vacuum chamber, the chuck and the probe card being arranged inside the innermost radiation shield.

3. The testing device according to claim 1 or 2, **characterised in that** the cooling unit is thermally connected to the one or more nested radiation shields.

4. The testing device according to any of the preceding claims, **characterised in that** the cooling unit is a dry cryostat using a closed loop helium circulation.

5. The testing device according to any of the preceding claims, **characterised in that** the probe card comprises a plurality of heat conducting layers which are thermally connected to each other.

6. The testing device according to claim 5, **characterised in that** the thickness of the heat conducting layers is less than 1 mm.

7. The testing device according to claim 5 or 6, **characterised in that** the heat conducting layers are made of copper, copper alloy, gold, gold alloy, silver or silver alloy.

8. The testing device according to any of the preceding claims, **characterised in that** the chuck comprises a plurality of heat conducting pins for holding the wafer on a base plate of the chuck.

9. The testing device according to claim 8, **characterised in that** the heat conducting pins are attached to the periphery of the base plate.

10. The testing device according to claim 8 or 9, **characterised in that** at least one of the heat conducting pins is attached with a spring to the periphery of the base plate, the spring being movable in the plane of the base plate.

11. The testing device according to any of claims 8 to 10, **characterised in that** an outer end of the heat conducting pins has a shape of a truncated cone enabling to press the wafer against the base plate.
